## Europäisches Patentamt
## European Patent Office
## Office européen des brevets

(19)

(11) Numéro de publication : **0 135 401**
**B1**

(12)
# FASCICULE DE BREVET EUROPÉEN

(45) Date de publication du fascicule du brevet :
27.07.88

(51) Int. Cl.⁴ : **H 01 L 21/76, H 01 L 21/20**

(21) Numéro de dépôt : **84401208.8**

(22) Date de dépôt : **13.06.84**

(54) Procédé de fabrication de composants semiconducteurs isolés dans une plaquette semi-conductrice.

(30) Priorité : **21.06.83 FR 8310243**

(43) Date de publication de la demande :
**27.03.85 Bulletin 85/13**

(45) Mention de la délivrance du brevet :
**27.07.88 Bulletin 88/30**

(84) Etats contractants désignés :
**DE FR GB IT NL**

(56) Documents cités :
**EP-A- 0 032 211**
**EP-A- 0 045 848**
**EP-A- 0 060 761**
**EP-A- 0 080 851**
**GB-A- 2 065 370**
**PATENTS ABSTRACTS OF JAPAN, vol. 5, no. 159(E-77)(831), 14 octobre 1981**
**IBM TECHNICAL DISCLOSURE BULLETIN, vol. 24, no. 7B, décembre 1981, pages 3684-3688, New York, USA; H.H. HANSEN et al.: "Improved device packing density"**
**INTERNATIONAL ELECTRON DEVICES MEETING, San Francisco, 13-15 décembre 1982, pages 224-227, IEEE, New York, USA; K.Y. CHIU et al.: "The SWAMI - A defect free and near-zero bird's-beak local oxidation process and its application in VLSI technology"**
**INTERNATIONAL ELECTRON DEVICES MEETING, San Francisco, 13-15 décembre 1982, pages 241-244, IEEE, New York, USA; N. ENDO et al.: "Novel device isolation technology with selective epitaxial growth"**
**PATENTS ABSTRACTS OF JAPAN, vol. 6, no. 144(E-122)(1022), 3 août 1982**
**PATENTS ABSTRACTS OF JAPAN, vol. 6, no. 205(E-136)(1083), 16 octobre 1982**

(73) Titulaire : **SGS-THOMSON MICROELECTRONICS S.A.**
**101, bld Murat**
**F-75016 Paris (FR)**

(72) Inventeur : **Borel, Joseph**
**THOMSON-CSF SCPI 173, bld Haussmann**
**F-75379 Paris Cedex 08 (FR)**

(74) Mandataire : **Guérin, Michel et al**
**THOMSON-CSF SCPI 19, avenue de Messine**
**F-75008 Paris (FR)**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

La présente invention concerne un procédé de fabrication de composants semiconducteurs isolés dans une plaquette semiconductrice et, plus particulièrement, un tel procédé compatible avec des substrats semiconducteurs de type utilisé en technologie bipolaire ; c'est-à-dire une technologie dans laquelle une couche épitaxiée d'un second type de conductivité est formée sur un substrat du premier type de conductivité, des couches enterrées du deuxième type de conductivité pouvant être prévues en des emplacements choisis localisés à l'interface entre le substrat et la couche épitaxiée.

Habituellement, en technologie bipolaire, les divers composants individuels d'un circuit intégré sont placés dans des zones cernées par des murs d'isolement, mais le fond de ces zones correspond au substrat ou à une couche enterrée et ne repose pas réellement sur une couche isolante, l'isolation étant obtenue par une jonction PN à condition que le substrat soit convenablement polarisé. Ce non-isolement réel du fond des caissons peut, dans certains cas, nuire au bon fonctionnement du circuit intégré et complique en tout cas la tâche du concepteur qui doit toujours prévoir que le substrat se trouve à un niveau de polarisation extrême. De plus, divers effets parasites se produisent du fait que le substrat peut constituer l'une des couches d'un transistor ou d'un thyristor parasite.

Il est souhaitable dans la pratique de pouvoir disposer dans un circuit intégré bipolaire d'au moins un certain nombre de transistors MOS ou bipolaires complètement isolés du substrat ou dont au moins les couches de drain, de source, de collecteur ou d'émetteur sont isolées de ce substrat. C'est l'objet de la présente invention que de prévoir de tels composants et un procédé de fabrication de ces composants compatible avec la technologie des circuits intégrés bipolaires.

Pour atteindre cet objet, la présente invention prévoit un procédé de fabrication de composants semiconducteurs isolés sur une plaquette semiconductrice du type utilisé en technologie bipolaire, comprenant un substrat d'un premier type de conductivité sur lequel est formée une couche épitaxiée du deuxième type de conductivité, des couches enterrées du second type de conductivité pouvant être prévues en des emplacements choisis à l'interface entre le substrat et la couche épitaxiée. Ce procédé comprend essentiellement les étapes suivantes : creuser partiellement la couche épitaxiée dans des zones de périmètre choisi délimitées à l'aide d'une première couche de masquage isolante ; déposer une deuxième couche de masquage isolante ; ouvrir localement une fenêtre dans cette deuxième couche isolante au fond de la zone creusée ; déposer du silicium polycristallin dans les zones creusées ; rééépitaxier ce silicium polycristallin à partir de sa zone en contact avec le silicium sous-jacent à l'emplacement de la fenêtre ; et former dans les zones rééépitaxiées monocristallines les composants souhaités.

Selon un aspect de la présente invention, il peut être prévu de former ensuite un mur isolant traversant la couche rééépitaxiée, le fond de ce mur correspondant à la fenêtre ménagée dans la deuxième couche isolante.

Ces caractéristiques principales de la présente invention ainsi que d'autres seront exposées plus en détail dans la description suivante de modes de réalisation particuliers faite en relation avec les figures jointes parmi lesquelles :

— les figures 1A à 1C représentent une succession d'étapes du procédé selon la présente invention,

— la figure 2 illustre un aspect de la présente invention,

— les figures 3A à 3C représentent des étapes successives d'une variante du procédé selon la présente invention,

— les figures 4 à 6 représentent des exemples de composants formés en utilisant le procédé selon la présente invention.

Dans ces diverses figures, ainsi que d'une figure à l'autre, aucune échelle n'est respectée, au contraire les dimensions relatives latérales et transversales des diverses couches ont été arbitrairement dilatées ou contractées pour simplifier la lisibilité des figures ou, tout simplement, pour les rendre compatibles avec le format des planches de dessins.

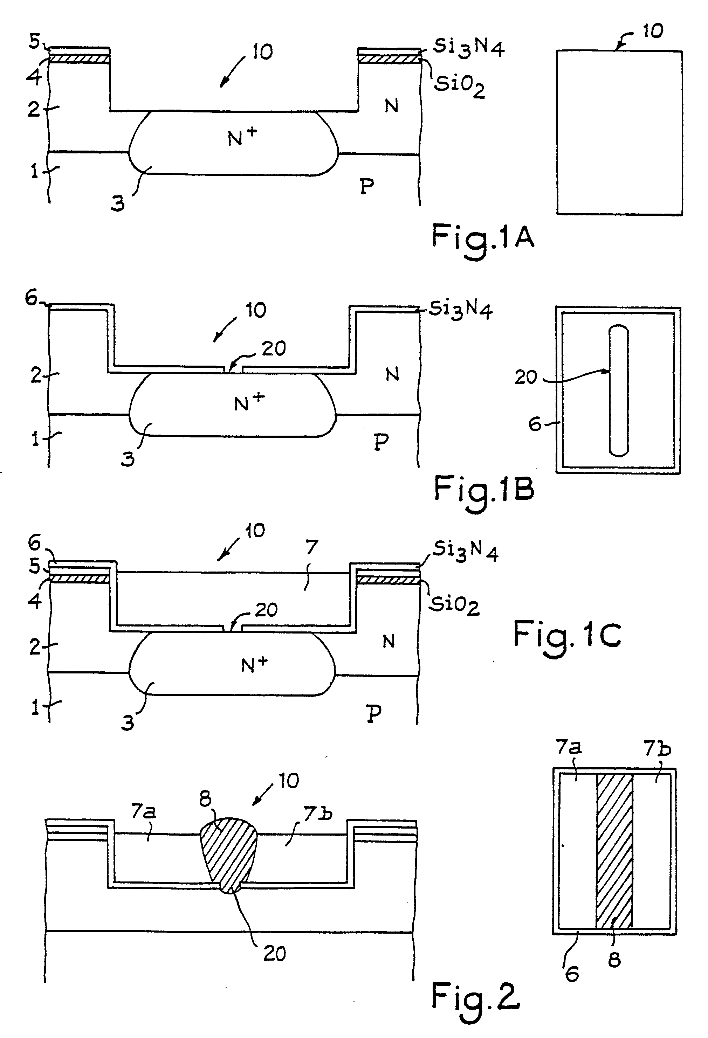

Les figures 1A à 1C sont des vues en coupe schématique illustrant des étapes du procédé selon la présente invention, les figures 1A et 1B étant accompagnées de vues de dessus extrêmement schématiques destinées uniquement à faciliter la compréhension du lecteur, sans pour autant que les formes représentées doivent être considérées limitativement.

En figure 1A, on peut voir une portion de plaquette de circuit intégré bipolaire comprenant sur un substrat de silicium 1 de type P une couche épitaxiée 2 de type N. Il a également été représenté une zone enterrée localisée 3 à l'interface du substrat et de la couche épitaxiée. On verra que la prévision de cette couche enterrée localisée est optionnelle. D'autre part, cette couche enterrée a été représentée avec une certaine étendue transverse. En fait, elle n'acquiert son étendue qu'au cours des étapes thermiques successives du processus de fabrication. Sur la couche épitaxiée 2, on peut voir successivement une couche de silice 4, elle-même revêtue d'une couche de nitrure 5. Ces couches 4 et 5 forment un masque composite qui a permis la réalisation d'une zone évidée 10, par exemple de contour rectangulaire comme cela est représenté dans la vue de dessus schématique. Cet évidement 10 a une profondeur de l'ordre de la moitié de l'épaisseur de la couche épitaxiée. Par exemple, une profondeur de 0,5 micron si la couche épitaxiée a une épaisseur de l'ordre de 0,8 à 1 micron.

Comme le représente la figure 1B, une couche de nitrure de silicium 6 est ensuite uniformément déposée sur la plaquette (éventuellement après une brève oxydation) et cette couche est ouverte au fond de l'évidement, par tout moyen connu, pour former une fenêtre 20 faisant apparaître le silicium monocristallin sous-jacent. La fenêtre 20 a par exemple la forme d'une fente située sensiblement au milieu du fond de l'évidement.

Dans l'étape suivante, qui est illustrée en figure 1C, l'évidement 10 est rempli par tout moyen connu de silicium polycristallin 7. Parmi ces moyens connus, on peut citer celui qui consiste à déposer uniformément du silicium polycristallin sur l'ensemble de la plaquette sur une épaisseur suffisante pour avoir une surface sensiblement plane, puis à attaquer chimiquement la couche de silicium polycristallin jusqu'à atteindre la couche de nitrure de silicium 6. D'autres procédés de planarisation plus élaborés peuvent être utilisés. On pourra aussi faire appel à des techniques de rodage mécanique suivi d'un décapage chimique.

Ensuite, on procède à la recristallisation sous forme de monocristal du silicium polycristallin déposé. Ceci est effectué à partir de la fenêtre 20 en contact avec le silicium monocristallin sous-jacent, par échauffement. Cet échauffement peut être provoqué par le déplacement à la surface de la plaquette d'un élément chauffant ou par une irradiation thermique résultant d'une exposition à une source lumineuse intense laser ou non. On trouve donc dans l'évidement 10 une zone de silicium monocristallin, éventuellement dopé selon que le silicium polycristallin a été déposé à l'état pur ou en présence d'un dopant. Cette zone de silicium monocristallin est isolée par la couche de nitrure 6 du reste de la plaquette de silicium sauf à l'emplacement de la fenêtre 20. Dans cette zone de silicium polycristallin, on pourra former des composants élémentaires de diverses manières, comme cela sera exposé ci-après.

Comme le représente la figure 2, si l'on veut obtenir des zones de silicium monocristallin complètement isolées de la masse du silicium environnant, il est possible de « boucher » la fenêtre 20 faisant communiquer la zone de silicium polycristallin avec l'ensemble de la plaquette de silicium. Pour cela, on pourra, comme le représente la figure 2, prévoir une oxydation localisée du silicium monocristallin 7 en regard de la fenêtre 20. Cette zone d'oxyde, désignée par la référence 8, peut par exemple être formée en déposant à nouveau une couche de nitrure sur la plaquette de silicium monocristallin gravée aux emplacements en regard de l'ouverture 20 ; après quoi, l'on procède classiquement à une oxydation thermique. Selon un autre mode de réalisation, il est possible de profiter de la présence partout, sauf aux emplacements de la fenêtre 20, de la couche isolante 6. On déposera alors une deuxième couche isolante à la surface de la zone 7 ouverte sensiblement en regard de la fenêtre 20 et l'on procédera à une anodisation électrolytique pour transformer la portion de silicium monocristallin disposée entre les deux fenêtres en regard en silicium poreux qui est ensuite facilement oxydé. Tout autre procédé pour former une couche d'isolant localisé pourra être utilisé par exemple le creusement d'un sillon comblé d'isolant. On obtient, comme le représente la figure 2, deux zones distinctes 7a et 7b entièrement isolées dans le cas où la fenêtre 20 était, comme cela a été décrit précédemment, une fente sensiblement médiane ménagée dans la couche de nitrure disposée au fond de l'ouverture 10. Il aurait également été possible de prévoir l'ouverture 20 à un autre emplacement, par exemple le long d'un bord du fond de l'ouverture 20. La zone oxydée se trouverait donc alors disposée latéralement et l'on obtiendrait une seule zone isolée. On notera, dans le cas de la figure 2, que l'on n'a pas représenté de couche enterrée localisée de type $N^+$. En effet, dans ce cas, cette couche enterrée ne présente pas d'avantages particuliers.

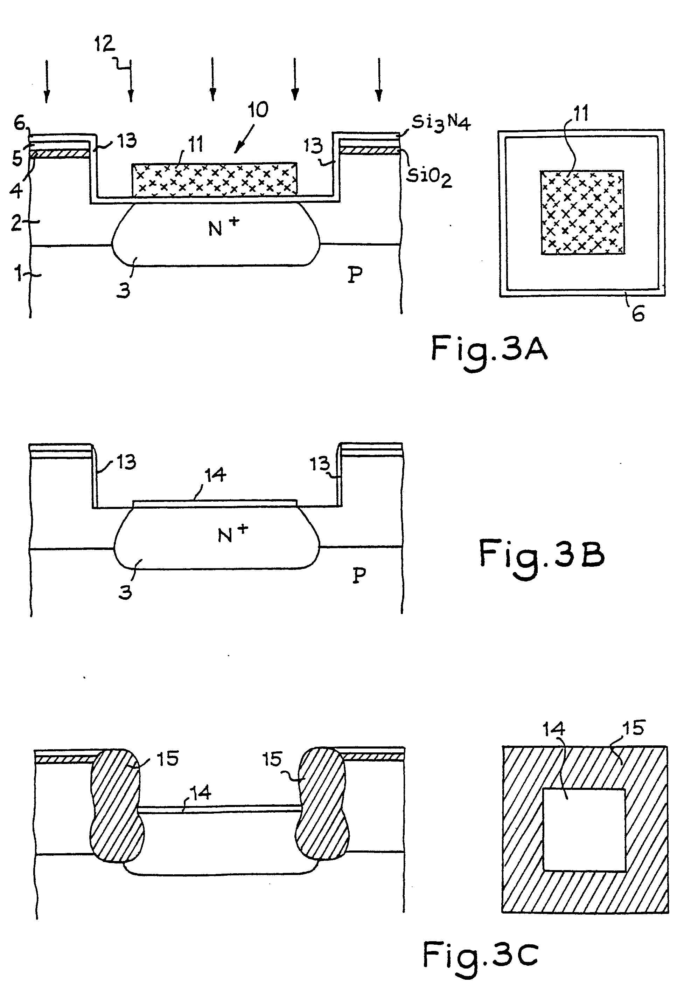

Les figures 3A à 3C représentent des vues en coupe de variantes de réalisation des premières étapes du procédé selon la présente invention. Dans ces figures, des couches ou zones analogues à celles illustrées dans les figures 1A et 1B sont désignées par les mêmes références. Aux figures 3A et 3C sont associées des vues de dessus très schématiques.

Comme le représente la figure 3A, on part d'une structure correspondant sensiblement à celle illustrée à la figure 1B avant la formation de la fenêtre 20. On retrouve un substrat 1 de type P, une couche épitaxiée 2 de type N, une couche enterrée 3 de type $N^+$, un premier masque constitué d'une couche d'oxyde 4 et d'une couche de nitrure 5 ayant servi à délimiter une ouverture 10 et une deuxième couche de nitrure 6 déposée après formation de l'ouverture 10. Après ces étapes, on dépose une couche de résine 11 localisée au fond de l'évidement 10 à l'exception de la périphérie de cet évidement. Puis, l'on procède à une irradiation ionique directive symbolisée par des flèches 12. En conséquence, les surfaces horizontales de la couche de nitrure 6 sont fortement irradiées, sauf à l'emplacement protégé par la couche de résine 11 qui n'est pas irradié du tout, tandis que les portions verticales 13 de la couche de nitrure disposées sur les flancs de l'évidement 10 ne sont que faiblement irradiées. Cette irradiation est propre à conférer des vitesses d'attaque différentes aux zones irradiées et non irradiées. Ainsi, comme le représente la figure 3B, quand on a procédé à une attaque de la couche de nitrure, celle-ci est complètement éliminée dans le fond de l'évidement 10 et à la périphérie de ce fond tandis que la couche de nitrure reste en place dans toute la partie centrale principale 14 de l'évidement et que la couche de nitrure 13, sur les parois verticales de l'évidement, est amincie.

En conséquence, quand on procède ensuite à une oxydation thermique, celle-ci se développe à partir des zones apparentes de silicium à la périphérie et au fond de l'évidement et est poursuivie jusqu'à ce que les parties amincies de nitrure 13 soient complètement oxydées. Alors, il reste en place au moins une partie de l'épaisseur de la couche de nitrure 14 au fond de l'évidement. On obtient donc une structure sensiblement telle que représentée en figure 3C dans laquelle la zone d'oxyde développé à la périphérie de l'évidement est désignée par la référence 15. La durée de l'oxydation et l'épaisseur de la zone amincie de nitrure 13 sont choisies d'une part comme cela a été indiqué pour que la couche de nitrure 13 soit complètement oxydée en fin de processus, mais aussi pour que la zone oxydée atteigne l'interface entre le substrat 1 et la couche épitaxiée 2 (si la profondeur de l'évidement 10 est sensiblement égale à la moitié de l'épaisseur de la couche épitaxiée, la zone d'oxyde 13 affleurera sensiblement au niveau de la surface apparente de cette couche épitaxiée).

Après l'étape illustrée en figure 3C, on ménage dans la couche de nitrure 14 une fenêtre 20 du type illustré en figure 1B et l'on procède aux étapes ultérieures déjà décrites précédemment en relation avec la figure 1C.

Un avantage important de ce mode de réalisation est que, dans le cas où l'on ne « rebouche » pas l'ouverture 20, la zone de silicium réépitaxiée est en contact par cette ouverture avec l'ensemble de la couche épitaxiée sous-jacente ; la barrière d'oxyde 15 illustrée en figure 3C permet alors un isolement latéral. En outre, même dans le cas où l'on « rebouche » la fenêtre 20 de la façon décrite précédemment en relation avec la figure 2, la couche mince de nitrure 6 peut présenter des défauts et alors les zones de silicium monocristallin 7a, 7b risquent de se trouver en contact avec la couche épitaxiée. Si l'on a prévu la barrière d'isolement 15, un défaut aura une importance plus négligeable.

Un autre avantage du procédé illustré en relation avec les figures 3A à 3C est qu'il est parfaitement compatible avec des techniques d'isolement qui peuvent actuellement être couramment utilisées dans le cadre de la réalisation de circuits intégrés bipolaires dans les cas où l'on veut obtenir une bonne planéité de la surface du dispositif et éviter en outre les phénomènes liés à l'apparition des becs d'oiseau associés aux oxydations profondes localisées. En effet, si on suit les étapes illustrées dans les figures 3A à 3C mais sans prévoir la couche de résine 11, on obtient un mur d'isolement qui ne déborde pratiquement pas par rapport à la surface du silicium et dans lequel aucun bec d'oiseau n'apparaît.

A partir des structures décrites précédemment, on pourra former dans les diverses zones isolées des composants élémentaires isolés totalement ou partiellement du silicium environnant.

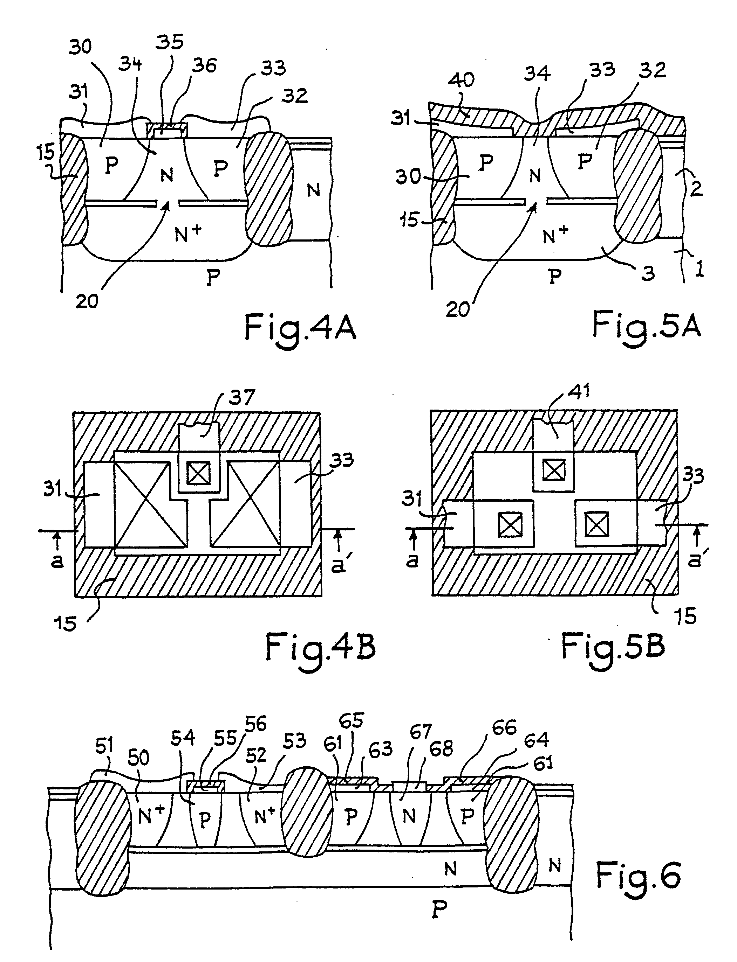

Les figures 4A et 5A représentent des vues en coupe d'exemples de transistors PNP formés en utilisant la structure selon l'invention dans laquelle le fond comprend une ouverture communiquant avec le silicium sous-jacent. Ces structures ne seront pas décrites en détail car elles résultent de modes de fabrication aujourd'hui classiques analogues ou identiques à ceux décrits précédemment dans EP-A-0 060 761 au nom de la demanderesse et dont le deuxième inventeur est l'inventeur de la présente demande.

Les figures 4B et 5B représentent de façon très schématique des ves de dessus correspondant respectivement aux figures 4A et 5A, ces coupes étant effectuées selon les plans a-a' indiqués sur les vues de dessus. Comme le montrent ces figures, on a ainsi réalisé des transistors PNP latéraux dans lesquels seules les faces latérales des zones P d'émetteur et de collecteur sont en contact avec la zone de base, le fond des zones P d'émetteur et de collecteur étant en contact avec une zone isolée. Ceci résout l'une des difficultés essentielles qui se posent avec les transistors PNP latéraux classiques dans lesquels il se produit une injection à partir du fond de la zone d'émetteur. La communication par la fenêtre 20 entre la zone N de base et la couche enterrée permet d'améliorer la conductivité d'un bout à l'autre de la base, ce qui est particulièrement avantageux dans le cas de la structure des figures 5A et 5B où un contact est pris seulement sur une extrémité de la zone de base sans que tout le sommet de cette zone de base soit surdopé.

En figure 4A et 4B, la référence 30 désigne une couche de type P (par exemple émetteur) surmontée d'une couche de silicium polycristallin 31. La référence 32 désigne la couche de collecteur de type P surmontée d'une zone de silicium polycristallin 33. La base de type N 34 est également surmontée d'une zone de silicium polycristallin 35 entourée d'une couche isolante, par exemple de la silice, 36. En figure 4B, on peut également voir une métallisation 37 venant reprendre un contact à l'emplacement marqué d'une croix sur la couche de silicium polycristallin de base 35. En figure 5A et 5B, on retrouve les couches d'émetteur et de collecteur 30 et 32 revêtues de couches de silicium polycristallin 31 et 33, mais cette fois, il n'est pas prévu de couches de silicium polycristallin en contact avec la base sur toute sa longueur, la référence 40 désignant une couche d'oxyde. Dans ce cas, comme le montre la figure 5B, une métallisation 41 vient directement établir un contact avec la couche de base 34, en prévoyant éventuellement un puits de contact fortement dopé descendant vers la couche enterrée 3 de type $N^+$. Bien entendu, ces figures et leur description sont fortement schématiques et l'on pourra trouver des exemples de réalisation plus détaillés dans la demande de brevet citée précédemment.

La figure 6 décrit une application de la présente invention dans le cas où l'on part d'une structure telle que celle illustrée en figure 2 comprenant deux zones complètement isolées dans lesquelles il est possible de former, par exemple par les techniques décrites dans la demande de brevet citée ci-dessus, des transistors NPN et PNP ou d'autres composants élémentaires. Très schématiquement, le transistor NPN comprend une couche d'émetteur 50 revêtue d'une couche de silicium polycristallin 51, une couche de collecteur

52 revêtue d'une couche de silicium polycristallin 53 et une couche de base de type P 54 revêtue d'une couche de silicium polycristallin 55 isolée par une couche d'oxyde 56. Dans le cas des transistors PNP, les couches de collecteur et d'émetteur 61 et 62 sont revêtues de couches de silicium polycristallin 63 et 64 isolées par des couches d'oxyde 65 et 66. La zone de base 67 de type N est revêtue d'une couche de silicium polycristallin 68. Selon les performances souhaitées pour les transistors NPN et PNP, les deux moitiés de zones réépitaxiées pourront avoir le type de dopage initial ou un dopage correctif pourra être prévu pour l'une de ces deux zones.

La présente invention n'est pas limitée aux modes de réalisation qui ont été explicitement décrits, notamment de nombreuses variantes pourront en être déduites par l'homme de l'art dans le cadre de l'invention définie par les revendications en tenant compte des connaissances acquises au jour de la présente demande ; également, d'autres applications des zones semiconductrices isolées formées selon l'invention pourront être réalisées ; ainsi, on n'a décrit que des applications à des transistors bipolaires, mais l'on pourra envisager des applications à des transistors de type MOS, par exemple de type DMOS compatibles avec les technologies bipolaires ; de même, les divers modes de réalisation décrits précédemment pourront être combinés entre eux. On aura noté par exemple que la figure 6 combine la figure 2 avec la variante des figures 3A à 3C (isolation latérale par un mur de silice thermique).

**Revendications**

1. Procédé de fabrication de composants semiconducteurs, isolés totalement ou partiellement par diélectrique, sur une plaquette semiconductrice du type utilisé en technologie bipolaire comprenant un substrat (1) d'un premier type de conductivité sur lequel est formée une couche épitaxiée (2) du deuxième type de conductivité, des couches enterrées (3) du deuxième type de conductivité pouvant être prévues en des emplacements choisis à l'interface entre le substrat et la couche épitaxiée, caractérisé en ce qu'il comprend les étapes suivantes :

— creuser partiellement la couche épitaxiée dans des zones (10) de périmètre choisi délimité à l'aide d'une première couche de masquage isolante (4, 5),

— déposer sur les parois et au fond de la zone creusée une deuxième couche isolante (6) non-monocristalline,

— ouvrir localement une fenêtre (20) dans cette deuxième couche isolante au fond de la zone creusée,

— déposer du silicium polycristallin (7) dans les zones creusées,

— réépitaxier ce silicium polycristallin à partir de sa zone de contact avec le silicium sous-jacent à l'emplacement de la fenêtre (20), et

— former dans les zones réépitaxiées les composants souhaités.

2. Procédé selon la revendication 1, caractérisé en ce que la fenêtre (20) dans la deuxième couche isolante a sensiblement la forme d'une bande médiane.

3. Procédé selon la revendication 1, caractérisé en ce qu'il comprend en outre, après l'étape de réépitaxie, l'étape consistant à oxyder localement la couche de silicium polycristallin réépitaxiée sur toute son épaisseur en regard de la fenêtre.

4. Procédé de fabrication de composants semiconducteurs, isolés totalement ou partiellement par diélectrique, sur une plaquette semiconductrice du type utilisé en technologie bipolaire comprenant un substrat (1) d'un premier type de conductivité sur lequel est formée une couche épitaxiée (2) du deuxième type de conductivité, des couches enterrées (3) du deuxième type de conductivité pouvant être prévues en des emplacements choisis à l'interface entre le substrat et la couche épitaxiée, ce procédé étant caractérisé en ce qu'il comprend les étapes suivantes :

— creuser partiellement la couche épitaxiée dans des zones (10) délimitées à l'aide de masques appropriés (4, 5),

— déposer sur les parois et au fond de la zone creusée une couche de nitrure de silicium (6),

— masquer par un masque de résine (11) le fond des zones creusées à l'exception de la périphérie de ces zones,

— procéder à une irradiation (12) d'ions conférant des vitesses d'attaque distinctes aux portions de couches de nitrure irradiées et non irradiées, cette irradiation agissant sur une profondeur au plus égale à celle de la couche de nitrure (6),

— procéder à une attaque chimique de façon à enlever une épaisseur correspondant à celle de la couche de nitrure de sorte que, au fond des zones creusées, la partie masquée de la deuxième couche de nitrure ne soit pas affectée, tandis qu'à la périphérie le semiconducteur sous-jacent est mis à nu, et que, sur les flancs des zones creusées, demeure une portion amincie de la couche de nitrure,

— oxyder le silicium apparent au moins jusqu'à atteindre la frontière entre le substrat et la couche épitaxiée,

— ouvrir localement la couche de nitrure selon une fenêtre (20) au fond des zones creusées,

— déposer du silicium polycristallin dans les zones creusées,

— réépitaxier ce silicium polycristallin à partir de sa zone en contact avec le silicium sous-jacent à l'emplacement des fenêtres, et

— former dans les zones réépitaxiées les composants souhaités.

5. Procédé selon la revendication 4, caractérisé en ce qu'il comprend en outre, après l'étape de réépitaxie, l'étape consistant à oxyder localement la couche de silicium polycristallin réépitaxiée sur toute son épaisseur en regard des fenêtres.

## Claims

1. A method for manufacturing semiconductor components which are entirely or partly isolated by a dielectric material, on a semiconducting plate of the type used in a bipolar technology, comprising a substrate (1) of a first conductivity type on which an epitaxiated layer (2) of the second conductivity type is formed, embedded layers (3) of the second conductivity type being possibly provided at positions selected at the interface between the substrate and the epitaxiated layer, characterized in that it includes the following steps :
— partly hollowing out the epitaxiated layer in zones (10) of a selected perimeter, delimited by means of a first insulating mask layer (4, 5),
— depositing a second insulating non-monocristalline layer (6) on the walls and the bottom of the hollow zone,
— locally opening a window (20) in this second insulating layer at the bottom of the hollow zone,
— depositing polycristalline silicium (7) in the hollow zones, .
— re-epitaxiating this polycristalline silicium from its zone of contact with the underlying silicium at the position of the window (20), and
— forming the desired components in the re-epitaxiated zones.

2. A method according to claim 1, characterized in that the window (20) in the second insulating layer is substantially shaped like a median strip.

3. A method according to claim 1, characterized in that it further comprises, consecutive to the step of re-epitaxiation, a step consisting in a local oxidation of the re-epitaxiated polycristalline silicium layer over its entire thickness facing the window.

4. A method for manufacturing semiconductor components which are entirely or partly isolated by a dielectric material, on a semiconducting plate of the type used in a bipolar technology, comprising a substrate (1) of a first conductivity type on which an epitaxiated layer (2) of the second conductivity type is formed, embedded layers (3) of the second conductivity type being possibly provided at positions selected at the interface between the substrate and the epitaxiated layer, this method being characterized in that it includes the following steps :
— partly hollowing out the epitaxiated layer in the zones (10) delimited by means of appropriated masks (4, 5),
— depositing a silicium nitride layer (6) on the walls and at the bottom of the hollow zone,
— masking by a resin mask (11) the bottom of the hollow zones with the exception of the periphery of these zones,
— performing a ion irradiation (12) comparing distinct attack speeds to the portions of the irradiated and not irradiated nitride layers, this irradiation extending its effect over a depth at most equal to that of the nitride layer (6),

— proceeding to a chemical attack such that a thickness corresponding to that of the nitride layer is withdrawn in order not to affect the masked portion of the second nitride layer at the bottom of the hollow zones, while the underlying semiconductor is bared at the periphery, and that a portion of reduced thickness of the nitride layer remains on the slopes of the hollow zones,
— oxidizing the bared silicium at least up to the frontier between the substrate and the epitaxiated layer,
— locally opening the nitride layer according to a window (20) at the bottom of the hollow zones,
— depositing polycristalline silicium in the hollow zones,
— re-epitaxiating the polycristalline silicium from the zone in contact with the underlying silicium at the position of the windows, and
— forming the desired components in the re-epitaxiated zones.

5. A method according to claim 4, characterized in that it further comprises, consecutive for the re-epitaxiation step, the step consisting in locally oxidizing the re-epitaxiated layer of polycristalline silicium over the entire thickness facing the windows.

## Patentansprüche

1. Verfahren zur Herstellung von ganz oder teilweise durch ein Dielektrikum isolierten Halbleiterbauteilen auf einer halbleitenden Platte von der Art, die in der Bipolartechnik Verwendung findet, mit einem Substrat (1) eines ersten Leitfähigkeitstyps, auf dem eine Schicht des zweiten Leitfähigkeitstyps (2) epitaxiiert ist, wobei eingebettete Schichten (3) des zweiten Leitfähigkeitstyps an ausgewählten Stellen zwischen dem Substrat und der epitaxiierten Schicht vorgesehen sein können, dadurch gekennzeichnet, daß es folgende Verfahrensschritte aufweist :
— die epitaxiierte Schicht wird in Zonen (10), deren Umfang mithilfe einer ersten isolierenden Maskenschicht (4, 5) begrenzt wird, teilweise ausgehöhlt,
— auf die Seitenwände und den Boden der ausgehöhlten Zone wird eine zweite isolierende nicht-monokristalline Schicht (6) aufgebracht,
— ein Fenster (20) wird örtlich in dieser zweiten isolierenden Schicht am Boden der ausgehöhlten Zone geöffnet,
— polykristallines Silicium (7) wird in den ausgehöhlten Zonen aufgebracht,
— dieses polykristalline Silicium wird im Bereich des Fensters (20) ausgehend von der Kontaktzone mit dem darunterliegenden Silicium erneut epitaxiiert, und
— die gewünschten Bauteile werden in den erneut epitaxiierten Zonen ausgebildet.

2. Verfahren nach Anspruch 1, dadurch gekennzeichnet, daß das Fenster (20) in der zweiten isolierenden Schicht im wesentlichen die Form eines Mittelbandes besitzt.

3. Verfahren nach Anspruch 1, dadurch gekennzeichnet, daß es außerdem nach dem Verfahrensschritt der erneuten Epitaxiierung einen Verfahrensschritt enthält, bei dem die erneut epitaxiierte Schicht polykristallinen Siliciums gegenüber dem Fenster in ihrer ganzen Dicke örtlich oxidiert wird.

4. Verfahren zur Herstellung von ganz oder teilweise durch ein Dielektrikum isolierten Halbleiterbauteilen, auf einer halbleitenden Platte von der Art, die in der Bipolartechnik Verwendung findet, mit einem Substrat (1) eines ersten Leitfähigkeitstyps, auf dem eine Schicht des zweiten Leitfähigkeitstyps (2) epitaxisch gebildet ist, wobei eingebettete Schichten (3) des zweiten Leitfähigkeitstyps an ausgewählten Stellen zwischen dem Substrat und der epitaxiierten Schicht vorgesehen sein können, dadurch gekennzeichnet, daß es folgende Verfahrensschritte aufweist :
— die epitaxiierte Schicht wird teilweise in Zonen (10), die mithilfe geeigneter Masken (4, 5) begrenzt sind, ausgehöhlt,
— auf den Wänden und dem Boden der ausgehöhlten Zone wird eine Schicht aus Siliciumnitrid (6) aufgebracht,
— durch eine Harzmaske (11) wird der Boden der ausgehöhlten Zonen mit Ausnahme der Peripherie dieser Zonen abgedeckt,
— man führt eine Ionenbestrahlung (12) durch, durch die unterschiedliche Ätzgeschwindigkeiten den bestrahlten und nicht bestrahlten Bereichen der Nitridschichten verliehen werden, wobei diese Bestrahlung höchstens bis zu einer Tiefe der Nitridschicht (6) wirkt,
— man führt eine chemische Ätzung durch, so daß eine Schicht einer Dicke entsprechend der der Nitridschicht entfernt wird, so daß am Boden der ausgehöhlten Zonen der maskierte Bereich der zweiten Nitridschicht nicht angegriffen wird, während an der Peripherie der darunterliegende Halbleiter freigelegt wird, und daß an den Flanken der ausgehöhlten Zonen ein verdünnter Bereich der Nitridschicht verbleibt,
— das offenliegende Silicium wird mindestens bis zum Erreichen der Grenze zwischen dem Substrat und der epitaxiierten Schicht oxidiert,
— die Nitridschicht wird gemäß einem Fenster (20) am Boden der ausgehöhlten Zonen geöffnet,
— polykristallines Silicium wird in den ausgehöhlten Zonen aufgebracht,
— dieses polykristalline Silicium wird ausgehend von seiner Kontaktzone mit dem darunterliegenden Silicium an der Stelle der Fenster erneut epitaxiert und
— in den erneut epitaxiierten Zonen werden die gewünschten Bauteile ausgebildet.

5. Verfahren nach Anspruch 4, dadurch gekennzeichnet, daß außerdem nach der erneuten Epitaxie die Schicht aus erneut epitaxiiertem polykristallinem Silicium über ihre ganze Dicke hinweg gegenüber den Fenstern lokal oxidiert wird.

Fig.1A

Fig.1B

Fig.1C

Fig.2

Fig.3A

Fig.3B

Fig.3C

Fig.4A

Fig.5A

Fig.4B

Fig.5B

Fig.6